Europäisches Patentamt

(19) European Patent Office (11) Numéro de publication: **0 130 901**

Office européen des brevets **B1**

(12) **FASCICULE DE BREVET EUROPÉEN**

(45) Date de publication du fascicule du brevet: (51) Int. Cl.⁴: **G 01 R 33/022,** G 01 R 33/032
04.11.87

(21) Numéro de dépôt: **84401335.9**

(22) Date de dépôt: **26.06.84**

(54) **Tête de mesure pour appareil de mesure de vecteur de gradient de champ magnétique, appareil de mesure comprenant une telle tête, et procédé de mesure.**

(30) Priorité: **04.07.83 FR 8311073**

(43) Date de publication de la demande:
**09.01.85 Bulletin 85/2**

(45) Mention de la délivrance du brevet:
**04.11.87 Bulletin 87/45**

(84) Etats contractants désignés:
**DE GB IT**

(56) Documents cité:
**EP-A-0 030 876**
**US-A-3 703 682**
**US-A-4 327 327**

(73) Titulaire: **THOMSON- CSF, 173, Boulevard Haussmann, F-75379 Paris Cédex 08 (FR)**

(72) Inventeur: **Doriath, Gérard, THOMSON- CSF SCPI 173, bld Haussmann, F-75379 Paris Cedex 08 (FR)**
Inventeur: **Hartemann, Pierre, THOMSON- CSF SCPI 173, bld Haussmann, F-75379 Paris Cedex 08 (FR)**
Inventeur: **Martin, Joel, THOMSON- CSF SCPI 173, bld Haussmann, F-75379 Paris Cedex 08 (FR)**

(74) Mandataire: **Lepercque, Jean, THOMSON- CSF SCPI 19, avenue de Messine, F-75008 Paris (FR)**

LIBER, STOCKHOLM 1987

## Description

La présente invention se rapporte aux dispositifs de mesure de vecteur de gradient de champ magnétique. Elle concerne plus particulièrement une tête de mesure permettant de mesurer le vecteur de gradient de champ magnétique entre deux points de l'espace ainsi qu'un appareil de mesure de vecteur de gradient de champ magnétique utilisant une telle tête.

On sait mesurer avec précision la valeur d'un champ magnétique en un point donné. Cette exigence de précision conduit à concevoir des appareils d'une sensibilité telle que leurs mesures peuvent être affectées par les fluctuations du champ magnétique ambiant. C'est ainsi par exemple que certains magnétomètres permettent de mesurer de faibles champs magnétiques de l'ordre du nano-Tesla alors qu'il est courant que le champ magnétique ambiant présente des amplitudes de variations atteignant quelques dizaines à quelques centaines de nano-Teslas dans un spectre de fréquences s'étendant du continu à quelques dizaines de Hertz.

Pour effectuer des mesures de champs magnétiques précises et pouvoir les corriger en fonction des variations du champ magnétique ambiant, on a la possibilité d'effectuer avec un magnétomètre non directif différentes mesures en plusieurs points de la zone de mesure. On établit ainsi une carte du champ magnétique. Cette méthode présente l'inconvénient d'être longue.

On peut également utiliser des magnétomètres directifs, tels que les magnétomètres décrits dans la demande de brevet français N° 79 30721 ainsi que dans la première addition à ce brevet publié sous le N° 2 517 831. Dans ce cas, deux magnétomètres pourraient faire la mesure de gradient à condition que leurs axes de mesures soient parfaitement alignés. Mais un tel alignement pose des problèmes de réalisation. Ces problèmes sont d'autant plus difficile à résoudre que les champs à mesurer sont faibles.

C'est pourquoi, l'invention permet de résoudre ces problèmes de réalisation en ce qui concerne l'alignement des axes de mesure de ces organes de mesure.

L'invention a donc pour objet une tête de mesure pour appareil de mesure pour appareil de mesure de vecteur de gradient de champ magnétique caractérisée en ce qu'elle comprend un dispositif d'émission permettant d'émettre un faisceau lumineux polarisé linéairement; une première et une deuxième cellules en matériau magnétique, chaque cellule comportant une face d'entrée et une face de sortie alignées selon l'axe du faisceau de lumière et permettant, en son sein, une propagation guidée du faisceau ainsi qu'une rotation de la direction de polarisation du faisceau pendant sa propagation; au moins un moyen de mesure de rotation de polarisation associés à une cellule selon l'axe du faisceau lumineux, recevant le faisceau après traversée de la cellule associée et fournissant un signal de mesure;
- un premier bobinage de compensation alimenté par un premier courant de compensation permettant d'induire un champ magnétique continu réglable de compensation dans la première cellule et un deuxième bobinage de compensation alimenté par un deuxième courant de compensation permettant d'induire un autre champ magnétique continu réglable de compensation dans la deuxième cellule.

Des moyens de calcul de différence recevant des signaux proportionnels auxdits courants de compensation et fournissant en échange une information représentative du gradient de champ magnétique.

Une tête de mesure pour appareil de mesure de vecteur de gradient de champ magnétique est connue par le US-A-4 327 327.

L'invention concerne également un procédé de mesure de gradient de champ magnétique selon la revendication 9 ainsi qu'un appareil mettant en oeuvre la tête de mesure de l'invention et le procédé de mesure selon la revendication 11.

L'invention sera mieux comprise et d'autres caractéristiques apparaîtront à l'aide de la description qui suit, en référence aux figures annexées parmi lesquelles:
- la figure 1 représente schématiquement une tête de mesure selon l'invention dans laquelle un laser est placé entre deux cellules de mesure;
- la figure 2 représente schématiquement une tête de mesure selon l'invention dans laquelle un laser est placé d'un même côté par rapport à deux cellules de mesure;
- la figure 3 représente un schéma explicatif d'une variante de la figure 2;
- la figure 4 représente un exemple de réalisation concrète de la tête de mesure de la figure 1;
- la figure 5 représente un exemple de réalisation des circuits de commande de la tête de mesure de la figure 1 et constituant avec la tête de mesure l'appareil de mesure selon l'invention;
- la figure 6 représente un exemple de réalisation concrète des circuits de commande de la tête de mesure des figures 2 et 3 et constituant avec la tête de mesure l'appareil de mesure selon l'invention.

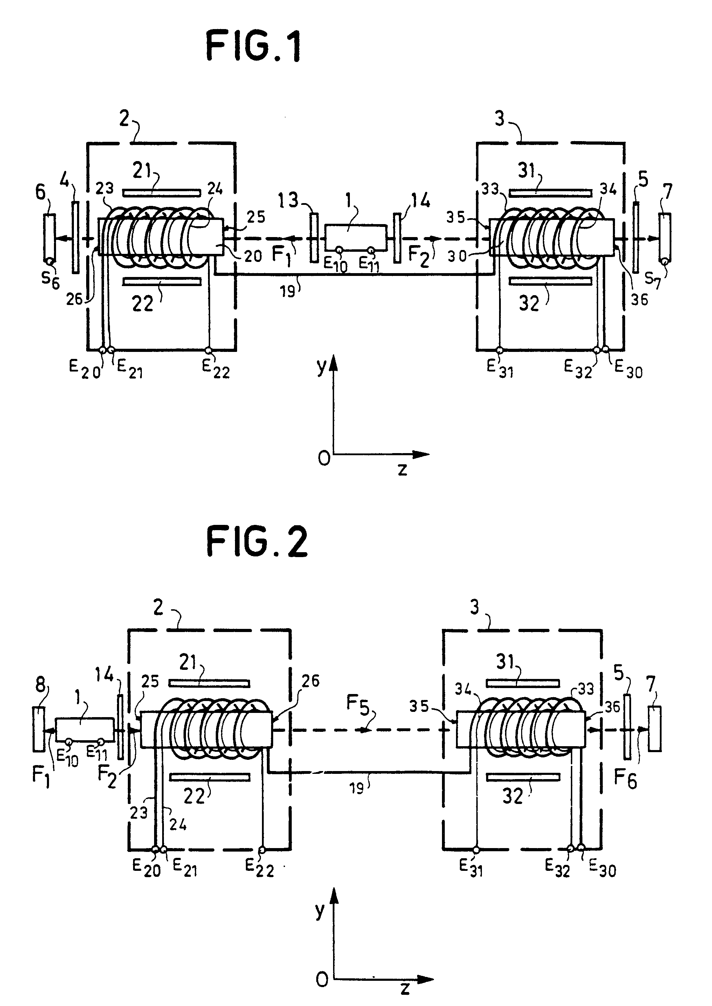

La tête de mesure de la figure 1 comprend une source laser à semiconducteur ou diode laser 1, deux polariseurs 13 et 14, deux cellules de mesure 2 et 3, deux analyseurs 4 et 5 et deux diodes photodétectrices 6 et situés dans un plan yOz.

La diode laser 1 émet à partir de deux de ses faces opposées deux faisceaux lumineux F1 et F2 collimatés dont les axes sont rigoureusement dans le prolongement l'un de l'autre. La surface émissive de chaque face a typiquement pour dimensions 0,2 micron par 15 microns. Une telle diode est alimentée par une tension électrique déterminée appliquée à ces connexions d'entrée E10 et E11.

La cellule de mesure 2 comporte une plaquette 20 taillée dans un grenat de gadolinium et de gallium dit GGG dont les dimensions longueur par largeur et par épaisseur sont d'environ 5 x 3 x 0,7 mm. Sur la surface de GGG on a fait pousser par épitaxie une couche relativement épaisse de YIG répondant sensiblement à la composition $Gd_{0,45} Y_{2,55} Ga_{0,9} Fe_{4,1} O_{12}$. L'épaisseur obtenue peut être comprise entre 5 et 110 microns et une valeur typique est de 20 microns.

Une telle épaisseur de YIG permet de faire propager la lumière de manière guidée mais multimode, et dans ces conditions l'effet Faraday dû au champ magnétique se manifeste uniquement par une rotation du plan de polarisation de la lumière et non plus par une conversion du mode TM en mode TE. Ceci permet de coupler le faisceau lumineux par les faces terminales de la couche YIG. Dans la description qui va suivre on considèrera dans l'utilisation de la plaquette 20, le rôle fonctionnel de la couche de YIG.

La cellule de mesure 2 comporte également un bobinage d'excitation 23 et un bobinage de compensation 24, tous deux concentriques à l'intérieur desquels est placée la plaquette 20, ainsi que deux pièces polaires 21 et 22 situées de part et d'autre de la plaquette 20 et induisant un champ magnétique continu dans la plaquette 20 selon le plan principal de la plaquette et transverse à la direction de propagation de la lumière dans la plaquette.

La cellule de mesure 3 est constituée de manière identique à celle de la cellule de mesure 2. En particulier le bobinage 33 présente les mêmes caractéristiques que le bobinage 23 auquel il est connecté en série par le fil de connexion 19 de telle sorte qu'alimentés par un même courant ces deux bobinages induisent des champs magnétiques identiques dans les deux plaquettes 20 et 30. Il est à noter que ces deux bobinages 23 et 33 pourraient être un seul bobinage englobant les deux plaquettes 20 et 30.

Les deux cellules de mesure 2 et 3 sont situées de part et d'autre de la diode laser sur les trajets des faisceaux F1 et F2. La plaquette 20 de la cellule 2 reçoit le faisceau F1 sur sa face d'entrée 25 et le retransmet par sa face de sortie 26 à l'analyseur 4 et à la diode photodétectrice 6. Il en est de même pour la plaquette 30 de la cellule de mesure 3 en ce qui concerne le faisceau F2, l'analyseur 5 et la diode photodétectrice 7.

On va maintenant décrire le fonctionnement de l'une des cellules de mesure, 2 par exemple, plongée dans un champ magnétique à mesurer.

La diode laser 1 est alimentée par ses bornes d'entrée E10 et E11 à l'aide d'une source appropriée non représentée. Elle fournit un faisceau lumineux F1 d'une puissance de quelques milliwatts à la longueur d'onde de 1,3 microns. Après traversée du polariseur 13, le faisceau F1 est couplé à la plaquette 20 par la face d'entrée 25. La plaquette 20 joue le rôle de guide d'onde. Le champ magnétique à mesurer a pour effet d'induire, dans la plaquette 20, un effet Faraday qui se manisfeste par une rotation du plan de polarisation de la lumière. Cette rotation est proportionnelle à l'intensité de la composante du champ magnétique selon la direction de propagation de la lumière, c'est-à-dire l'axe Oz. On a donc, intérêt à orienter l'ensemble de la tête de mesure représentée en figure 1 dans le champ magnétique à mesurer de telle façon que le faisceau F1 soit dirigé selon les lignes de ce champ magnétique.

Par ailleurs, les pièces polaires 21 et 22 induisent dans la plaquette 20 un champ magnétique dirigé selon l'axe Oy de telle sorte qu'en l'absence de champ à mesurer, le vecteur aimantation soit transverse et que l'effet d'un champ à mesurer selon l'axe Oz soit maximal. Il convient de préciser que ce champ transverse fournit par les pièces 21 et 22 sature les plaquettes a une valeur pouvant atteindre la valeur de 1 oersted.

La rotation du plan de polarisation due au champ à mesurer est détectée, après transmission par la face 26 de la plaque 20 et traversée de l'analyseur 4, par la diode photodétectrice 6. Celle-ci fournit sur sa sortie S6 un signal de mesure vers des dispositifs de mesure non représentés.

La rotation du plan de polarisation de la lumière n'est pas une fonction linéaire du champ magnétique à mesurer le long de la direction de propagation du faisceau F1 (axe Oz). Il est donc difficile de traduire le résultat de mesure obtenu sur la sortie S6 en valeur de champ magnétique mesuré. On utilise donc une méthode de zéro. Pour cela, on alimente le bobinage d'excitation 23 à l'aide d'un courant alternatif. Sur la figure les bobinages 23 et 33 des cellules 2 et 3 sont alimentés en série par les connexions d'entrée E20 et E30. Le bobinage 23 induit dans la plaquette 20 un champ magnétique alternatif parallèle à la direction de propagation du faisceau F1, c'est-à-dire selon l'axe Oz, et donc parallèle au champ à mesurer. Celui-ci est modulé par le champ alternatif fournit par le bobinage 23. L'intensité de la lumière détectée par la diode photodétectrice 6 est donc modulée. En l'absence de champ magnétique à mesurer, l'intensité de la lumière varie selon une loi ne contenant que des harmoniques paires du signal d'excitation appliqué au bobinage 23. La présence d'un champ magnetique à mesurer selon l'axe Oz donne lieu à l'apparition d'harmoniques impaires. L'amplitude du fondamental varie en fonction de la valeur du champ à mesurer. Pour réaliser la méthode de zéro on alimente le bobinage de compensation 24, par ses bornes d'entrée E21 et E22, en courant continu à l'aide de circuits d'alimention non représentés. Le bobinage 24 induit dans la plaquette 20, un champ magnétique continu selon la direction du faisceau F1, c'est-à-dire selon la direction du champ à mesurer. En réglant la valeur du courant continu en sens et en amplitude de façon appropriée telle que le champ continu induit compense le champ à mesurer, celui-ci n'a plus d'effet sur la rotation du plan de polarisation du faisceau F1. Il suffit alors de mesurer la valeur du courant continu fourni au bobinage 24 pour en déduire la valeur du champ mesuré.

La cellule de mesure 2 a donc permis de mesurer un champ magnétique. La cellule de mesure 3 fonctionne de la même manière et permet également de mesurer un champ magnétique. La différence des courants continus fournis aux bornes d'entrée 21, 22 du bobinage de compensation donne la différence des amplitudes des champs magnétiques mesurés aux emplacements des cellules de mesure 2 et 3. Par ailleurs, ces cellules et étant orientées selon le même axe et selon la direction du champ à mesurer, la différence des courants continus mesurés représente la valeur du vecteur du gradient de champ magnétique.

La tête de mesure selon l'invention permet donc en plaçant les cellules de mesure 2 et 3 sur les trajets des faisceaux lumineux émis par la diode laser 1, et utilisant la propriété d'unidirectionalité des faisceaux lumineux émis pour aligner avec précision les cellules de mesure 2 et 3, de mesurer la valeur d'un vecteur de gradient de champ magnétique.

La figure 2 représente une tête de mesure dans laquelle la diode laser 1 est placée d'un même côté par rapport aux cellules de mesure 2 et 3. Celles-ci sont rigoureusement alignées selon la direction d'un faisceau emis par la diode laser 1.

Le faisceau F1 émis par la diode laser 1 est dirigé sur une diode photodétectrice 8 qui délivre un signal et permet par des moyens non représentés et connus de régler la puissance d'alimentation et donc la puissance d'émission de la diode laser 1.

Le faisceau F2 de la diode laser 1 est transmis à un polariseur 14 qui le transmet à la face d'entrée 25 de la plaquette 29 de la cellule 2. Celle-ci le retransmet par la face de sortie 26 sous forme d'un faisceau F5 à la face d'entrée 35 de la plaquette 30 de la cellule 3. Enfin, le faisceau F6 issue de la face 36 est transmis par l'analyseur 5 à une cellule photodétectrice 7.

Le fonctionnement des cellules de mesure 2 et 3 est identique à celui des cellules de mesure de la figure 1. En fournissant aux entrées E21 et E22 du bobinage 24 et aux entrées E31 et E32 du bobinage 34 des courants continus appropriés, les effets des champs magnétiques aux emplacements des deux cellules de mesure sont compensés. La différence des courants continus fournis permet d'obtenir la valeur du gradient de champ magnétique. La différence de cette disposition par rapport à celle de la figure 1 réside dans le fait que le faisceau F1 et la diode photodétectrice 8 sont utilisés pour régler la puissance d'émission de la diode laser 1.

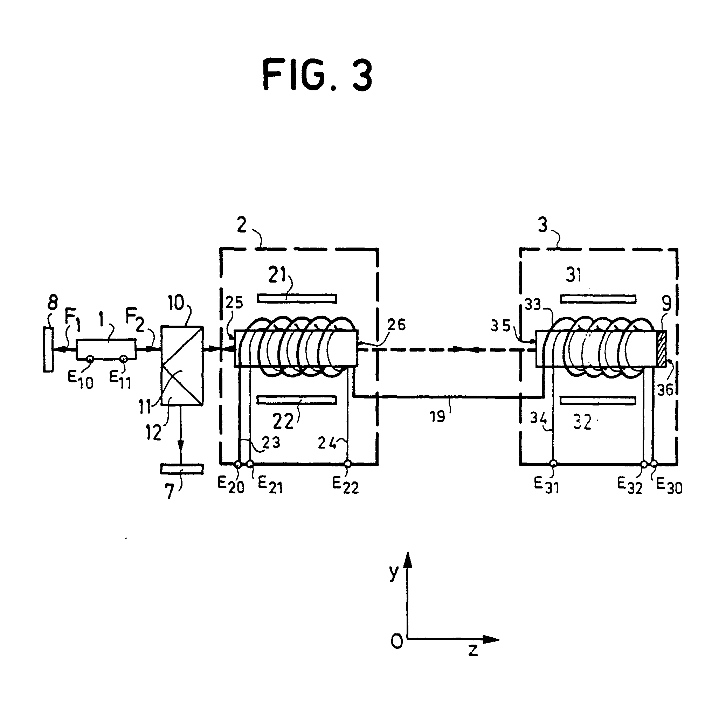

La figure 3 représente une tête de mesure dans laquelle le faisceau lumineux effectue un aller-retour dans les cellules de mesure 2 et 3.

Les cellules 2 et 3 sont de constitution identique à celles des figures 1 et 2. par rapport à la tête de la figure 1, on a intercalé sur le trajet du faisceau F2 entre la diode laser 1 et la cellule de mesure 2, un système de prismes 10, 11, 12 permettant de renvoyer la lumière vers une diode photodétectrice 7. De plus, on a accolé contre la face de sortie 36 de la plaquette 30 de la cellule 3, un miroir 9.

De même que dans la tête de la figure 1, le faisceau F1 et la diode photodétectrice permettent de régler la puissance d'émission de la diode laser 1.

Le faisceau F2 en raison de sa polarisation est transmis par les prismes 10 et 11 à la cellule 2 qui le retransmet à la cellule 3. Le faisceau lumineux est réfléchi par le miroir 9 et retraverse la cellule 3 puis la cellule 2. Le système de prismes 10, 11, 12 réfléchit le faisceau fourni par la cellule 2 et le retransmet à la diode photodétectrice 7.

Le faisceau lumineux traverse donc deux fois chaque cellule. Il apparaît donc que les courants continus à fournir aux entrées E21, E22 du bobinage de compensation 24 et E31, E32 du bobinage de compensation 34 doivent être d'amplitude double de celle nécessaire pour compenser une seule traversée de chaque cellule comme dans le cas de la figure 2. La différence des courants fournis est donc le double de celle obenue avec un montage du type de la figure 2. La précision de mesure du gradient de champ magnétique est donc améliorée.

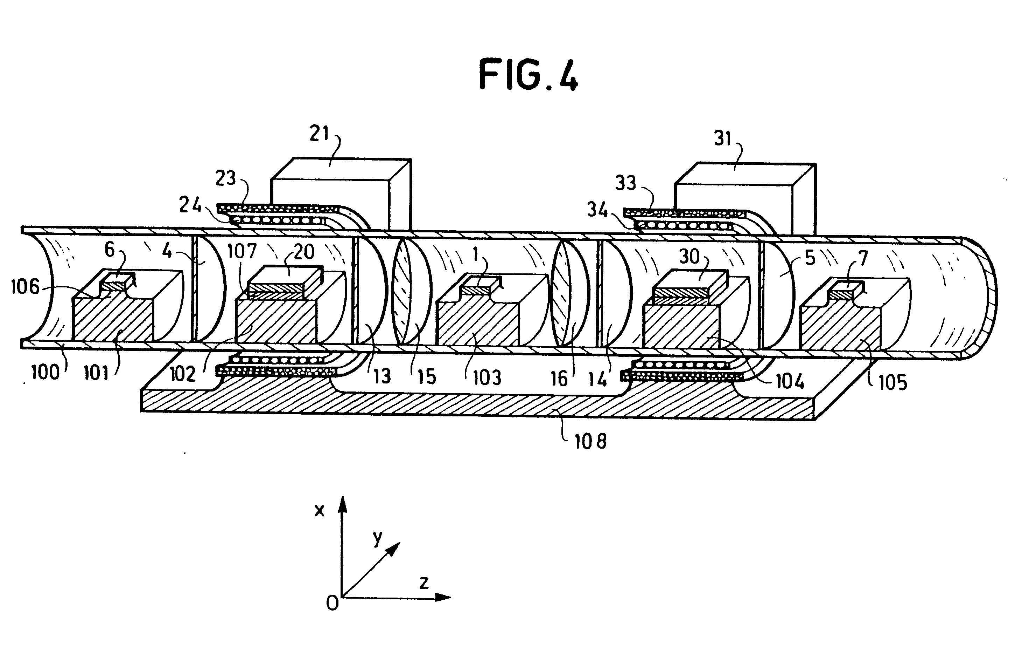

En se reportant à la figure 4, on va maintenant décrire un exemple de réalisation concrète d'une tête de mesure selon l'invention dessinée avec un système de repérage orthonormé Oxyz dont les axes Oy et Oz correspondent aux axes Oy et Oz des figures 1 à 3.

Cette tête de mesure correspond au schéma explicatif de la figure 1. Il est bien évident que des têtes de mesure conformes aux schémas de principe des figures 2 et 3 peuvent avoir un mode de réalisation similaire.

Cette tête de mesure comporte un tube rigide 100 dont l'intérieur est équipé d'embases fixes 101, 102, 103, 104 et 105 dont les faces principales sont parallèles. Les embases 101, 103 et 105 sont munies d'un bossage, tel que 106, dont la face supérieure a été soigneusement usinée. Sur les embases 101 et 105 sont montées les diodes photodétectrices 6 et 7 et sur l'embase 103 est montée la diode laser 1. Le réglage en hauteur de ces composants sur les embases est regle aisement a l'aide de cales non représentées. Sur les embases 102 et 104 sont montées les plaquettes 20 et 30 avec, à titre d'exemple, des cales telles que 107 pour le réglage en hauteur. Le réglage axial et l'immobilisation de tous ces composants sur leur embase se fait de manière connue à l'aide de moyens non représentés et, en position optimale, ils sont alignés sur la direction des faisceaux lumineux émis par la diode laser 1. Entre la diode laser 1 et les plaquettes 20 d'une part et 30 ont été montés les polariseurs 13 et 14 ainsi que des lentilles de focalisation 15 et 16. Entre les plaquettes 20 et 30 et les diodes photodétectrices ont été montés les analyseurs 4 et 5. Le montage des polariseurs 13 et 14, des lentilles 15 et 16 et des analyseurs 4 et 5 à l'intérieur du tube 100, de façon à ce qu'il n'introduise aucune déviation dans la direction des faisceaux lumineux, se fait d'une manière connue dans la technique de fabrication des instruments d'optique.

Les bobinages d'excitation 23 et 33, et les bobinages de compensation 24 et 34 sont montés autour du tube 100 de façon à être centrés dans le sens longitudinal sur les plaquettes 20 et 30.

Enfin l'ensemble est fixé sur un bâti support 108 sur lequel sont montées les pièces polaires 21, 31 (ainsi que 22 et 32 non représentées sur la figure 4), induisant un champ magnétique continu dans le plan des plaquettes 20 et 30 transversalement à la direction des faisceaux lumineux émis par la diode laser 1.

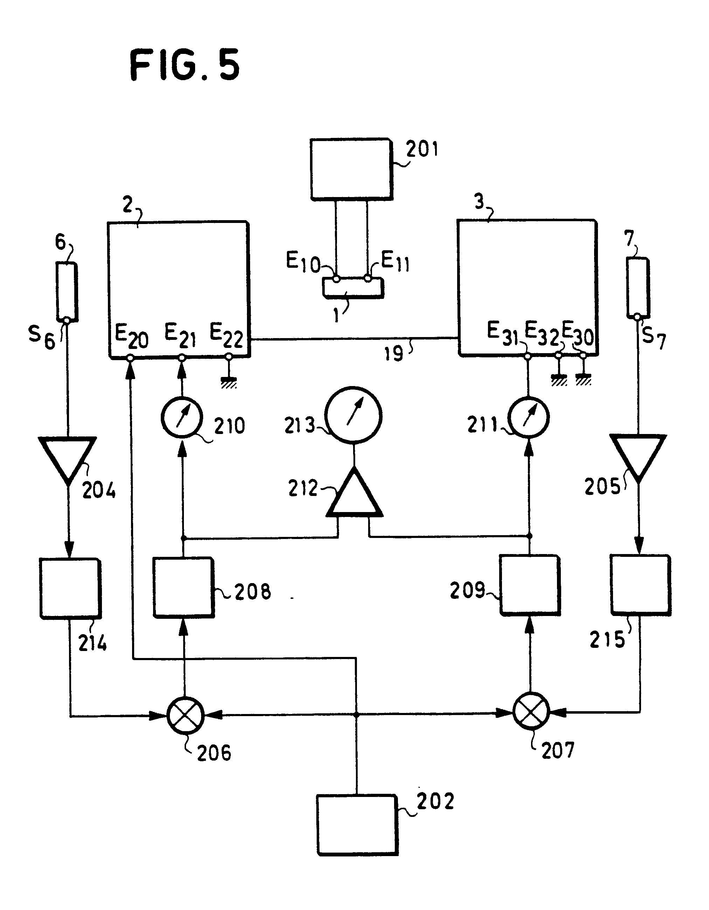

La figure 5 représente un exemple de réalisation des circuits de commande de la tête de mesure telle que décrite en relation avec la figure 1.

On retrouve sur cette figure la diode laser 1 avec ses bornes d'entrée E10 et E11, les cellules de mesure 2 et 3 avec leurs bornes d'entrée E20 à E22 et E30 à E32, les diodes photodétectrices 6 et 7 avec leurs bornes d'entrée S6 et S7. Les bornes d'entrée E22, E32 et E30 sont à la terre.

La diode laser est alimentée en courant par un circuit d'alimentation 201 connecté à ses bornes d'entrée E10 et E11. Pour une diode laser émettant dans l'infrarouge sous une longueur d'onde de 1,3 micron, une puissance lumineuse de 4 milliwatts est obtenue avec une intensité d'alimentation de 200 milliampères. Une telle puissance lumineuse permet parfaitement de faire fonctionner le dispositif à la sensibilité désirée.

Un oscillateur 202 fournit un signal à une fréquence fo relativement élevée, 100 KHz par exemple. Ce signal est appliqué à la borne d'entrée E20 de la cellule de mesure 2 et est retransmis à la cellule de mesure 3 par le fil de connexion 19. Un courant alternatif circule donc entre les bornes d'entrée E20 et E30 dans les bobinages d'excitation 23 et 33 (voir figure 1). Un champ alternatif est induit dans les plaquettes 20 et 30 selon la direction des faisceaux F1 et F2.

Les diodes photodétectrices 6 et 7 détectent respectivement les faisceaux F1 et F2 et délivrent des signaux sur leur sortie S6 et S7. En l'absence de composante de champ magnétique continu dirigée selon la direction de propagation des faisceaux, ces signaux ont une fréquence 2fo double de la fréquence de l'oscillateur.

Les signaux sont amplifiés par les amplificateurs 204, 205 puis filtrés par des filtres sélectifs 214, 215 à la fréquence fo.

Le signal en sortie de chaque filtre est comparé avec le signal fournit par l'oscillateur 202, dans un circuit de détection (206, 207) qui mesure à la fois l'amplitude de chacun d'eux à la fréquence du fondamentale et le changement de phase lors du passage par zéro. Les circuits de détection 206 et 207 ne fournissent pas de signal de sortie.

En présence d'une composante de champ magnétique continu dirigé selon la direction de propagation des faisceaux lumineux, les signaux détectés par les diodes photodétectrices 6 et 7 sont déformés par rapport aux signaux précédents. Le signal en sortie de chaque filtre 214, 215 comparé au signal fournit par l'oscillateur 202 donne lieu dans les circuits de détection 206 et 207 à l'émission d'un signal d'erreur en courant continu correspondant à la détection réalisée.

Le signal d'erreur fournit par le circuit de détection 206 est transmis à un amplificateur 208 qui fournit à l'entrée E21 de la cellule de mesure 2 un courant continu de niveau correspondant au signal d'erreur. Un courant continu circule dans le bobinage de compensation 24 entre les bornes d'entrée E21 et E22. Un champ magnétique continu est induit dans la plaquette 30.

De même, le signal d'erreur fournit par le circuit de détection 207 est transmis à un circuit d'alimentation en courant continu 209 qui fournit un courant continu à la cellule de mesure 3 et induit un champ magnétique continu dans la plaquette 30.

Un amplificateur différentiel 212 est branché en sortie des circuits d'alimentation 208 et 209. Il fournit sur sa sortie, vers un appareil de mesure 213, un signal correspondant à la différence des niveaux des signaux continus tournis aux bobinages de compensation 24 et 34. L'appareil de mesure 213 permet donc d'afficher la valeur du gradient de champ magnétique mesuré entre les deux emplacements où se trouvent les cellules de mesure 2 et 3.

Des appareils de mesure 210 et 211 sont insérés dans les circuits de transmission des signaux continus aux bornes d'entrée E21 et E31. Ils permettent de mesurer, si on le désire, la valeur des champs magnétiques aux emplacements des cellules de mesure 2 et 3.

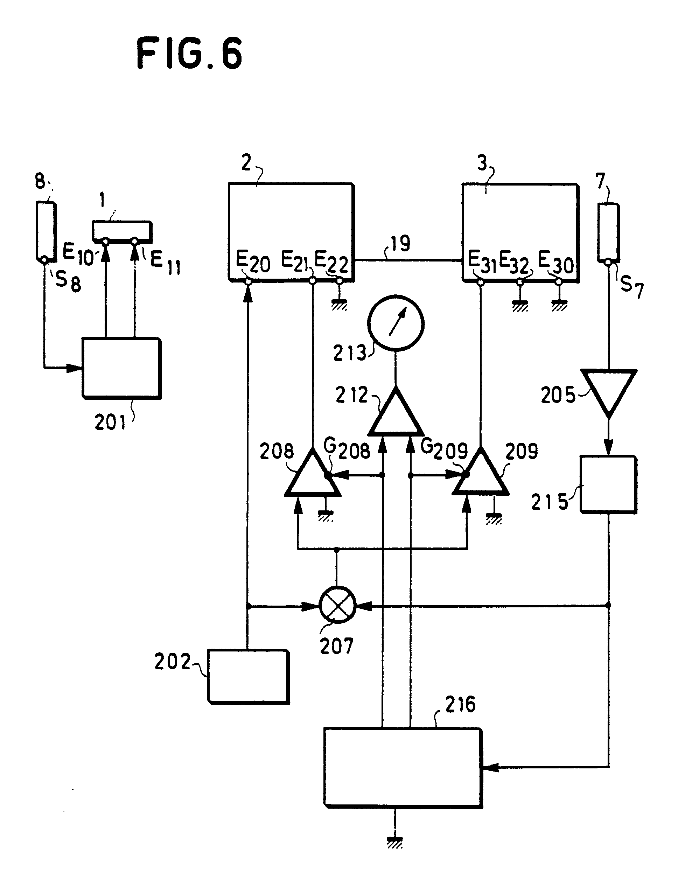

La figure 6 représente un diagramme de circuits permettant de faire fonctionner la tête de mesure des variantes telles que représentées par les figures 2 et 3. On retrouve sur cette figure la diode laser 1 et son circuit d'alimentation 201, les cellules de mesure 2 et 3 et les diodes photodétectrices 7 et 8.

La diode laser est alimentée comme précédemment par le circuit d'alimentation 201. En supplément, la diode photodétectrice recevant un faisceau lumineux de la diode laser fournit un signal sur sa sortie S8 et permet de réguler la puissance d'alimentation du circuit 201.

L'oscillateur 202 alimente en courant alternatif entre les bornes E20 et E30, les deux cellules de mesure 2 et 3.

La diode photodétectrice 7 fournit sur sa sortie S7 un signal qui est amplifié par l'amplificateur 205, puis filtré par un filtre 215. Comme précédemment, le filtre 215 fournit un signal qui est comparé au signal fournit par l'oscillateur 202 dans un circuit de comparaison 207. Le circuit de comparaison 207 fournit un signal d'erreur continu qui est amplifié par deux amplificateurs 208 et 209 et est appliqué aux bornes d'entrée E21 et E31 des cellules de mesure 2 et 3 pour alimenter les bobinages de compensation 24 et 34. Ceux-ci reçoivent donc un même courant qui correspond à une compensation maximale.

Les champs magnétiques étant supposés différents aux emplacements des deux cellules de mesure 2 et 3, il convient maintenant d'agir séparément sur les alimentations des deux bobines de compensation 23 et 34. Pour cela un circuit de régulation 216 est mis en fonctionnement par des moyens non représentés. Cette mise en fonctionnement peut être déclenchée manuellement ou automatiquement à l'aide d'une temporisation qui laisse le temps nécessaire aux circuits précédents de fonctionner. Le circuit de régulation 216 est du type Proportionnelle-Intégrale-Dérivée tel qu'utilisé couramment dans les systèmes de régulation de température par exemple. Il reçoit le signal fournit par le filtre 215, le compare à une valeur de référence à laquelle on donnera de préférence une valeur nulle. Un tel circuit peut fonctionner au choix selon trois modes différents fournissant des signaux de sortie soient proportionnels au résultat de la comparaison, soit une fonction intégrale, soit une fonction dérivée. Il fournit en réponse un signal de commande sur l'une des entrées de commande de gain G208 ou G209 des amplificateurs différentiels 208 et 209. L'un des amplificateurs différentiels 208 ou 209 fournit un signal permettant de compléter la compensation.

Un amplificateur différentiel 212 est connecté aux entrées de commande de gain G208 et G209. Il fournit, sur sa sortie, à un appareil de mesure 213, un signal correspondant à la différence des signaux de commande de gain des amplificateurs 208 et 209.

L'appareil de mesure 213 permet donc d'afficher la valeur du gradient de champ magnétique mesuré entre les deux emplacements où se trouvent les cellules de mesure 2 et 3.

**Revendications**

1. Tête de mesure pour appareil de mesure de vecteur de gradient de champ magnétique, caractérisée en ce qu'elle comprend un dispositif d'émission (1) permettant d'émettre un faisceau lumineux (F2) polarisé linéairement se propageant suivant un axe de propagation déterminé; une première et une deuxième cellules (2 et 3) en matériau magnétique, chaque cellule comportant une face d'entrée (25, 35) et une face de sortie (26, 36) alignées selon l'axe du faisceau de lumière et permettant, en son sein, une propagation guidée du faisceau ainsi qu'une rotation de la direction de polarisation du faisceau pendant sa propagation; au moins un moyen (7) de mesure de rotation de polarisation associé à une cellule (3) selon l'axe du faisceau lumineux, recevant le faisceau après traversée de la cellule associée et fournissant un signal de mesure;
- un premier bobinage de compensation (24) alimenté par un premier courant de compensation permettant d'induire un champ magnétique continu réglable de compensation dans la première cellule (2) et un deuxième bobinage de compensation (34) alimenté par un deuxième courant de compensation permettant d'induire un autre champ magnétique continu réglable de compensation dans la deuxième cellule (3);
- des moyens de calcul de différence (212) recevant des signaux proportionnels auxdits courants de compensation et fournissant en échange une information représentative du gradient de champ magnétique.

2. Tête de mesure selon la revendication 1, caractérisée en ce que le dispositif d'émission comporte un laser à semiconducteur (1) émettant, sur deux de ses faces opposées, un premier et un deuxième faisceaux (F1 et F2) ayant un même axe de propagation et polarisés linéairement, la première cellule (2) et un premier moyen de mesure (6) étant situés sur le trajet du premier faisceau (F1), la deuxième cellule (3) et un deuxième moyen de mesure (7) étant situés sur le trajet du deuxième faisceau (F2) de telle façon que chaque cellule reçoit un faisceau sur sa face d'entrée (25, 35) et le transmet par sa face de sortie (26, 36) au moyen de mesure (6, 7) qui lui est associé.

3. Tête de mesure selon la revendication 1, caractérisée en ce que la première et la deuxième cellules (2, 3) sont disposées d'un même côté par rapport au dispositif d'émission (1) en série sur un faisceau lumineux (F2) émis par celui-ci et qu'un seul moyen de mesure (7) est placé sur l'axe du faisceau de telle façon qu'il reçoive le faisceau lumineux (F2) émis par le dispositif d'émission (1) après traversée des deux cellules (2, 3).

4. Tête de mesure selon la revendication 1, caractérisée en ce qu'elle comporte associée à chaque cellule (2, 3), un moyen magnétique (24, 34) induisant dans chaque cellule (20, 30) correspondante un champ magnétique continu réglable de compensation dirigé selon l'axe de propagation du faisceau lumineux.

5. Tête de mesure selon la revendication 1, caractérisée en ce qu'elle comporte des moyens magnétiques (21, 22) induisant dans les deux cellules (2, 3) un champ magnétique continu orienté dans le plan de propagation du faisceau transversalement à l'axe de propagation.

6. Tête de mesure selon la revendication 1, caractérisée en ce qu'elle comporte des moyens magnétiques (23, 33) induisant dans les deux cellules (2 et 3) un champ magnétique alternatif de modulation orienté selon l'axe de propagation du faisceau lumineux.

7. Tête de mesure selon la revendication 6, caractérisée en ce que les moyens magnetiques induisant un champ magnétique alternatif de modulation sont un bobinage commun (23, 33) aux deux cellules (2, 3) et alimentée par un courant alternatif.

8. Tête de mesure selon la revendication 1, caractérisée en ce que chaque moyen de mesure comporte un analyseur (34) croisé par rapport à la direction de polarisation de la lumière émise par les moyens d'émission ainsi qu'un photodétecteur (7).

9. Procédé de mesure de gradient de champ magnétique entre des premier et deuxième points de mesure d'un milieu où règnent respectivement un premier champ magnétique local et un deuxième champ magnétique local tous deux de même direction, mettant en oeuvre la tête de mesure selon la revendication 1, caractérisé en ce qu'il comporte les étapes suivantes:

a) émission d'un faisceau lumineux polarisé passant par les deux points de mesure;

b) création, en chacun des deux points de mesure, de champs magnétiques de compensation équivalents d'une valeur telle que l'effet du premier champ magnétique local et du deuxième champ magnétique local sur la polarisation du faisceau lumineux soit minimisé;

c) variation sélective des deux champs magnétiques de compensation de telle façon que l'effet des deux champs magnétiques locaux sur la polarisation du faisceau lumineux soit annulé;

d) mesure desdites variations des deux champs magnétiques de compensation;

e) différenciation des résultats des mesures des variations des champs magnétiques de compensation.

10. Procédé de mesure selon la revendication 9, caractérisé en ce que la variation sélective des deux champs magnétiques de compensation s'effectue lorsqu'un équilibre de compensation des deux champs magnétiques locaux à l'aide d'un même champ magnétique de compensation est réalisé.

11. Appareil de mesure mettant en oeuvre une tête de mesure selon les revendications 5 et 8 et opérant selon le procédé selon la revendication 9, caractérisé en ce qu'il comprend un oscillateur (202) fournissant un signal alternatif aux premier et deuxième bobinages d'excitation (23 et 33); un premier circuit d'alimentation (208) fournissant un premier courant continu au premier bobinage de compensation (24); un deuxième circuit d'alimentation (209) fournissant un deuxième courant continu au deuxième bobinage de compensation (34); un premier circuit de comparaison (206) comparant le resultat de la mesure effectuée par le premier moyen (6) de mesure de rotation de polarisation au signal alternatif fourni par l'oscillateur (202) et fournissant en réponse un signal de commande au premier circuit d'alimentation (208) qui fournit alors un premier courant continu induisant un champ magnétique compensant le champ magnétique régnant dans la première cellule (2); un deuxième circuit de comparaison (207) comparant le résultat de la mesure effectuée par le deuxième moyen (7) de mesure de rotation de polarisation au signal alternatif fournit par l'oscillateur (202) et fournissant en réponse un signal de commande au deuxième circuit d'alimentation (209) qui fournit alors un deuxième courant continu induisant un champ magnétique compensant le champ magnétique régnant dans la deuxième cellule (3); un circuit de différence (212) calculant la différence des premier et deuxième courants continus, un dispositif d'affichage (213) affichant cette différence.

12. Appareil de mesure selon les revendications 3, 10 et 11, caractérisé en ce qu'il comporte un seul circuit de comparaison (207) connecté au seul moyen de mesure (7) et commandant de la même façon le premier circuit d'alimentation (208) et le deuxième circuit d'alimentation (209); un circuit de régulation (216) mis en fonctionnement séparément et connecté également au moyen de mesure (7), recevant le signal de mesure et fournissant sélectivement aux premier et deuxième circuits d'alimentation (208, 209) des signaux de commande de niveaux; un circuit de différenciation (212) connecté au circuit de régulation (216), recevant ces signaux de commande de niveaux et fournissant un signal de différence représentant la différence de ces signaux; un dispositif d'affichage recevant le signal de différence et affichant sa valeur.

**Patentansprüche**

1. Meßkopf für ein Gerät zur Messung des Vektors des magnetischen Feldgradienten, dadurch gekennzeichnet, daß er folgende Bestandteile enthält: eine Sendevorrichtung (1), die es erlaubt, einen linear polarisierten Lichtstrahl (F2) auszusenden, der sich in einer festgelegten Ausbreitungsachse ausbreitet; eine erste und eine zweite Zelle (2 und 3) aus magnetischem Material, wobei jede Zelle eine Eingangsfläche (25, 35) und eine Ausgangsfläche (26, 36) enthält, die hintereinander in der Achse des Lichtstrahls gelegen sind und in ihrem Inneren eine geführte Ausbreitung des Strahls wie eine Drehung seiner Polarisationsrichtung während seiner Ausbreitung ermöglichen; mindestens eine Vorrichtung (7) zur Messung der Drehung der Polarisation, die einer Zelle (3) in der Achse des Lichtstrahls zugeordnet ist, den Lichtstrahl nach dem Durchlaufen der damit verbundenen Zelle empfängt und ein Meßsignal liefert;

- eine erste Kompensationsspule (24), die von einem ersten Kompensationsstrom versorgt wird und es ermöglicht, in der ersten Zelle (2) ein stationäres, regelbares Kompensatinsmagentfeld zu induzieren, und eine zweite Kompensationsspule (34), die von einem zweiten Kompensationsstrom versorgt wird und es ermöglicht, in der zweiten Zelle (3) ein anderes stationäres, regelbares Kompensationsmagnetfeld zu induzieren;

- Mittel zur Differenzberechnung (212), die die zu den Kompensationsströmen proportionalen Signale empfangen und daraus eine den magnetischen Feldgradienten darstellende Information erzeugen.

2. Meßkopf nach Anspruch 1, dadurch gekennzeichnet, daß die Sendevorrichtung einen Halbleiterlaser (1) enthält, der auf seinen gegenüberliegenden Seiten einen ersten und einen zweiten Lichtstrahl (F1 und F2) aussendet, wobei die beiden Strahlen dieselbe Ausbreitungsachse haben und linear polarisiert sind, wobei ferner die erste Zelle (2) und die erste Meßvorrichtung (6) auf dem Ausbreitungsweg des ersten Strahls (F1) gelegen sind, die zweite Zelle (3) und die zweite Meßvorrichtung (7) auf dem Weg des zweiten Strahls (F2) gelegen sind, so daß jede Zelle einen Strahl auf ihrer Eingangsseite (25, 35) empfängt und ihn durch ihre Ausgangsseite (26, 36) der Meßvorrichtung (6, 7), die mit ihr verbunden ist, übermittelt.

3. Meßkopf nach Anspruch 1, dadurch gekennzeichnet, daß die erste und die zweite Zelle (2, 3) bezüglich der Sendevorrichtung (1) auf derselben Seite und hintereinander auf einem von ihr ausgesandten Lichtstrahl (F2) gelegen sind und daß eine einzige Meßvorrichtung (7) auf der Achse des Strahls so gelegen ist, daß sie den von der Sendevorrichtung (1) ausgesandten Lichtstrahl (F2) empfängt, nachdem er die beiden Zellen (2, 3) durchlaufen hat.

4. Meßkopf nach Anspruch 1, dadurch gekennzeichnet, daß er ein mit jeder Zelle (2, 3) verbundenes magnetisches Mittel (24, 34) enthält, das in jeder entsprechenden Zelle (20, 30) ein stationäres, regelbares Kompensationsmagnetfeld induziert, das in der Ausbreitungsachse des Lichtstrahls gerichtet ist.

5. Meßkopf nach Anspruch 1, dadurch gekennzeichnet, daß er magnetische Mittel (21, 22) enthält, die in den beiden Zellen (2, 3) ein stationäres Magnetfeld induzieren, das in der Ausbreitungsebene des Strahls senkrecht zur Ausbreitungsachse gerichtet ist.

6. Meßkopf nach Anspruch 1, dadurch gekennzeichnet, daß er magnetische Mittel (23, 33) enthält, die in den beiden Zellen (2 und 3) ein wechselndes Modulationsmagnetfeld induzieren, das in der Ausbreitungsrichtung des Lichtstrahls gerichtet ist.

7. Meßkopf nach Anspruch 6, dadurch gekennzeichnet, daß die magnetischen Mittel, die das wechselnde Modulationsfeld induzieren, eine den beiden Zellen (2, 3) gemeinsame Spule (23, 33) sind, die von einem Wechselstrom versorgt wird.

8. Meßkopf nach Anspruch 1, dadurch gekennzeichnet, daß jede Meßvorrichtung einen Analysator (34), der mit der Polarisationsrichtung des von den Sendemitteln ausgesandten Lichts über Kreuz steht, sowie einen Fotoempfänger (7) enthält.

9. Verfahren zum Messen des magnetischen Feldgradienten zwischen einem ersten und einem zweiten Meßpunkt in einem Gebiet, wo jeweils ein erstes lokales Magnetfeld und ein zweites lokales Magnetfeld herrschen, die beide die gleiche Richtung haben, unter Verwendung des Meßkopfs nach Anspruch 1, dadurch gekennzeichnet, daß es folgende Schritte enthält:

a) Aussenden eines polarisierten Lichtstrahls, der durch die beiden Meßpunkte geht;

b) Erzeugen von Kompensationsmagnetfeldern in jedem Meßpunkt, deren Wert so ist, daß die Wirkung des ersten lokalen Magnetfelds und des zweiten lokalen Magnetfelds auf die Polarisation des Lichtstrahls minimiert wird;

c) wahlweises Variieren der beiden Kompensationsmagnetfelder so, daß die Wirkung der beiden lokalen Magnetfelder auf die polarisation des Lichtstrahls ausgeregelt wird;

d) Messen der Variationen der beiden Kompensationsmagnetfelder;

e) Differenzieren der Meßergebnisse der Variationen der Kompensationsmagnetfelder.

10. Meßverfahren nach Anspruch 9, dadurch gekennzeichnet, daß die wahlweise Variation der beiden Kompensationsmagnetfelder ausgeführt wird, während ein Kompensationsgleichgewicht beider lokalen Magnetfelder mit Hilfe ein und desselben Kompensationsmagnetfelds erreicht wird.

11. Meßgerät unter Verwendung des Meßkopfs nach den Ansprüchen 5 bis 8 und des Verfahrens nach Anspruch 9, dadurch gekennzeichnet, daß es folgende Bestandteile enthält: einen Oszillator (202), der der ersten und der zweiten Anregungsspule (23 und 33) ein Wechselsignal liefert; einen ersten Versorgungskreis (208), der der ersten Kompensationsspule (24) einen ersten, stationären Strom liefert; einen zweiten Versorgungskreis (209), der der zweiten Kompensationsspule (34) einen zweiten, stationären Strom liefert; einen ersten Vergleichskreis (206), der das Meßergebnis, das mit der ersten Vorrichtung (6) zur Messung der Drehung der Polarisation erzielt wurde, mit dem vom Oszillator (202) gelieferten Wechselsignal vergleicht und daraus ein Steuersignal für den ersten Versorgungskreis (208) liefert, der dann einen ersten stationären Strom liefert, der ein Magnetfeld induziert, das das in der ersten Zeil (2) herrschende Magnetfeld kompensiert; einen zweiten Vergleichskreis (207), der das Meßergebnis, das mit der zweiten Vorrichtung (7) zur Messung der Drehung der Polarisation erzielt wurde, mit dem vom Oszillator (202) gelieferten Wechselsignal vergleicht und daraus ein Steuersignal für den zweiten Versorgungskreis (209) liefert, der seinerseits einen zweiten, stationären Strom liefert, der ein Magnetfeld induziert, das das in der zweiten Zelle (3) herrschende Magnetfeld kompensiert; einen Differenzkreis (212), der die Differenz zwischen dem ersten und dem zweiten stetigen Strom berechnet, eine Anzeigevorrichtung (213), die ddiese Differenz anzeigt.

12. Meßgerät nach den Ansprüchen 3, 10 und 11, dadurch gekennzeichnet, daß es einen einzigen Kompensationskreis (207) enthält, der mit der einzigen Meßvorrichtung (7) verbunden ist und der auf die gleiche Weise den ersten Versorgungskreis (208) und den zweiten Versorgungskreis (209) steuert; ferner einen Regelkreis (216), der getrennt wirksam ist und gleichermaßen mit der Meßvorrichtung (7) verbunden ist, der das Meßsignal empfängt und wahlweise dem ersten und dem zweiten Versorgungskreis (208, 209) Signale zur Pegelsteuerung liefert; außerdem einen Differenzierungskreis (212), der mit dem Regelkreis (216) verbunden ist, diese Pegelsteuerungssignale erhält und ein Differenzsignal liefert, das die Differenz dieser Signale darstellt; weiterhin eine Anzeigevorrichtung, die das Differenzsignal empfängt und seinen Wert anzeigt.

## Claims

1. Measuring probe of an apparatus for measuring the magnetic field gradient vector, characterized in that it comprises a transmission device (1) for transmitting a linearly polarized light beam (F2) propagating along a predetermined axis; a first and a second cell (2 and 3) of magnetic material, each cell comprising an entrance face (25, 35) and an outlet face (26, 36) aligned along the axis of the light beam and permitting a guided propagation of the beam and a rotation of the direction of polarization of the beam during its propagation within said cell; at least one means (7) for measuring the rotation of polarization associated with a cell (3) along the axis of the light beam, receiving the beam after it has crossed the associated cell and supplying a measurement signal;
- a first compensation winding (24) fed by a first compensation current for inducing a continuous adjustable magnetic compensation field in the first cell (2) and a second compensation winding (34) fed by a second compensation current for inducing another continuous adjustable magnetic compensation field in the second cell (3);
- difference calculating means (212) receiving signals which are proportional to said compensation currents and supplying, in exchange, an information representative of said magnetic field gradient.
2. Measuring probe according to claim 1, characterized in that the transmission device comprises a semiconductor laser (1) emitting from its two opposed faces a first and a second beam (F1 and F2) having the same axis of propagation and linear polarization, the first cell (2) and a first measuring means (6) lying on the path of the first beam (F1), the second cell (3) and a second measuring means (7) lying on the path of the second beam (F2) in such a manner that each cell receives a beam on its entrance face (25, 35) and transmits it through its outlet face (26, 36) to the measuring means (6, 7) associated therewith.

3. Measuring probe according to claim 1, characterized in that the first and the second cells (2, 3) are arranged on the same side with respect to the transmission device (1) in series on a light beam (F2) emitted therefrom, and that a single measuring means (7) is located on the axis of the beam in such a manner that it receives the light beam (F2) emitted by the transmission device (1) after crossing the two cells.

4. Measuring probe according to claim 1, characterized in that it comprises a magnetic means (24, 34) associated with each cell (2, 3) and inducing in each corresponding cell (20, 30) a continuous magnetic adjustable compensation field directed along the axis of propagation of the light beam.

5. Measuring probe according to claim 1, characterized in that it comprises magnetic means (21, 22) inducing in the two cells (2, 3) a continuous magnetic field oriented in the plane of propagation of the beam transverse to the axis of propagation.

6. Measuring probe according to claim 1, characterized in that it comprises magnetic means (23, 33) inducing in the two cells (2 and 3) a magnetic alternating modulation field oriented along the axis of propagation of the light beam.

7. Measuring probe according to claim 6, characterized in that the magnetic means inducing a magnetic alternating modulation field are made up by a coil (23, 33) which is common to the two cells (2, 3) and fed by an alternating current.

8. Measuring probe according to claim 1, characterized in that each measuring means comprises an analyzer (34) crossed with respect to the direction of polarization of the light emitted by the transmission means as well as a photodetector (7).

9. Method of measuring the magnetic field gradient between first and second measurement points of a medium where a first local magnetic field and a second magnetic local field, respectively, exist, both in the same direction, using the measurement probe according to claim 1, characterized in that it comprises the following steps:
a) emission of a polarized light beam passing through the two measuring points;
b) at each of the two measuring points magnetic compensation fields are generated which are equivalent to such a value that the effect of the first local magnetic field and the second magnetic local field on the polarization of the light beam is minimized;
c) selective variation of the two magnetic compensation fields in such a manner that the effect of the two local magnetic fields on the polarization of the light beam is reduced to zero;
d) measuring said variations of the two magnetic compensation fields;
e) differentiation of the measuring results of the magnetic compensation field variations.

10. Measuring method according to claim 9, characterized in that the selective variation of the two magnetic compensation fields is performed when a balance of compensation of the two local magnetic fields is obtained by means of the same magnetic compensation field.

11. Measuring apparatus using a measuring probe according to claims 5 and 8 and operating according to the method of claim 9, characterized in that it comprises an oscillator (202) supplying an alternating signal to the first and second excitation coils (23 and 33); a first feed circuit (208) supplying a first direct current to the first compensation coil (24); a second feed circuit (209) supplying a second direct current to the second compensation coil (34); a first comparator circuit (206) comparing the result of the polarization rotation measurement performed by the first measurement means (6) with the alternating signal supplied by the oscillator (202) and supplying, in response, a control signal to the first feed circuit (208) which then supplies a first direct current inducing a magnetic field compensating for the magnetic field existing in the first cell (2); a second comparator circuit (207) comparing the result of the polarization rotation measurement performed by the second measuring means (7) to the alternating signal supplied by the oscillator (202) and supplying, in response, a control signal to the second feed circuit (209) which then supplies a second direct current inducing a magnetic field compensating for the magnetic field existing in the second cell (3); a difference circuit (212) calculating the difference of the first and second direct currents, a display device (213) displaying this difference.

12. Measuring apparatus according to claims 3, 10 and 11, characterized in that it comprises a single comparator circuit (207) connected to the single measuring means (7) and controlling in a like manner the first feed circuit (208) and the second feed circuit (209); an adjustment circuit (216) which is made operative separately and is likewise connected to the measuring means (7), receives the measurement signal and selectively supplies level control signals to the first and second feed circuits (208, 209); a differentiating circuit (212) connected to the adjustment circuit (216) receiving these level control signals and supplying a difference signal representing the difference of these signals; a display device receiving the difference signal and displaying its value.

0 130 901

FIG.1

FIG.2

1

# FIG. 3

# FIG.4

0 130 901

FIG. 5

# FIG.6